Europäisches Patentamt

European Patent Office

Office européen des brevets

(19)

(11) Numéro de publication: **0 067 752**
**B1**

(12) **FASCICULE DE BREVET EUROPEEN**

(45) Date de publication du fascicule du brevet: **20.11.86**

(21) Numéro de dépôt: **82400981.5**

(22) Date de dépôt: **27.05.82**

(51) Int. Cl.⁴: **G 05 D 23/24,** H 01 L 23/56,
H 03 L 1/04

(54) Cellule de couplage thermique et enceinte thermostatée comportant une telle cellule.

(30) Priorité: **05.06.81 FR 8111216**

(43) Date de publication de la demande:
**22.12.82 Bulletin 82/51**

(45) Mention de la délivrance du brevet:
**20.11.86 Bulletin 86/47**

(84) Etats contractants désignés:
**CH DE GB IT LI NL**

(56) Documents cités:
**EP-A-0 004 233**
**DE-A-2 811 933**
**FR-A-1 535 492**
**FR-A-2 129 956**
**GB-A-1 114 497**
**GB-B-1 081 704**
**US-A-3 409 757**
**US-A-3 614 480**
**US-A-3 809 928**

**ELECTRONICS INTERNATIONAL, vol. 54, no. 7,
avril 1981, pages 130-132, New York (USA); M.
BURKETT et al.: "Plastic packaging cuts the
cost of rf power transistors"**

(73) Titulaire: **COMPAGNIE D'ELECTRONIQUE ET DE
PIEZO-ELECTRICITE - C.E.P.E.
44, rue de la Glacière
F-95100 Argenteuil (FR)**

(72) Inventeur: **Marotel, Gérard
THOMSON-CSF SCPI 173, bld Haussmann
F-75379 Paris Cedex 08 (FR)**
Inventeur: **Pribat, Didier
THOMSON-CSF SCPI 173, bld Haussmann
F-75379 Paris Cedex 08 (FR)**

(74) Mandataire: **Ruellan-Lemonnier, Brigitte et al
THOMSON-CSF SCPI 19, avenue de Messine
F-75008 Paris (FR)**

Courier Press, Leamington Spa, England.

**Description**

La présente invention concerne une cellule de couplage thermique entre un elément calorifique et un elément thermo-sensible pour la régulation thermique d'une enceinte, l'elément thermo-sensible étant à proximité de l'élément calorifique.

Dans sa constitution générale, un dispositif de chauffage à regulation thermique comporte essentiellement trois parties:

—une ou plusieurs sources produisant de l'énergie calorifique, sous l'action d'un courant électrique, énergie appliquée au corps à chauffer;

—un circuit de réglage du courant électrique dans les limites données, sous l'action d'une tension électrique de commande;

—un ou plusieurs organes de mesure de la température du corps à chauffer, délivrant la tension électrique de commande.

En fonctionnement, le circuit de réglage étant ajusté pour l'obtention d'une température désirée, toute veriation de température accidentelle de l'enceinte provoque de la part des organes de mesure de température, la production d'une tension électrique de commande qui, appliquée au circuit de réglage du courant électrique de la source d'énergie calorifique, fait varier dans le sens convenable, la valeur de cette énergie.

Un dispositif de ce type est décrit dans la demande de brevet européen EP—A—0 004 233. Il est constitué d'un circuit de mesure de température, comportant un pont de résistances dont certaines sont sensibles à la température, attaquant un amplificateur différentiel, et d'un circuit de chauffage dont les éléments calorigènes sont une chaîne de transistors montés en stabilisateurs de tension. Un circuit auxiliaire assure une limitation du courant maximal par action sur la base d'un transistor de commande.

De tels dispositifs procurent sans difficultés particulières des résultats satisfaisants lorsque les domaines de température et/ou les précisions sur la régulation restent dans des ordres de grandeur rencontrés habituellement dans l'industrie.

Cependant, dans certains domaines particuliers, tels que celui de la définition du temps par la génération de fréquences de haute précision, la mise en oeuvre des dispositifs en trois parties indiqués ci-dessus conduit à des modes de réalisation particuliers. Dans le cas d'une enceinte pour un oscillateur piézo-électrique dont la précision sur une fréquence donnée doit être de l'ordre de $10^{-9}$, la précision sur la température doit être inférieure au centième de degré Kelvin. La cellule de couplage thermique idéale entre l'élément calorifique et l'élément thermo-sensible est caractérisée par un couplage thermique optimal, une résistance thermique minimale entre l'élément calorifique et le corps à chauffer et une taille de ladite cellule minimale.

En effet, tout couplage thermique entre lesdits éléments a pour effet de diminuer la constante de temps de la boucle d'asservissement, diminuant ainsi le temps de réponse de l'élément calorifique et assurant une meilleure stabilisation en température en minimisant les fluctuations de température à court et moyen terme.

L'amélioration de la résistance thermique entre l'élément calorifique et le corps à chauffer a en soi pour conséquence de pouvoir diminuer la puissance thermique fournie par l'élément calorifique pour entretenir une température constante du corps à chauffer.

Le brevet FR—A—1 525 492 décrit une cellule de couplage thermique entre un élément calorifique et un élément thermo-sensible pour la régulation thermique d'une enceinte, l'élément calorifique et l'élément thermo-sensible étant disposés sur un même support conducteur thermique.

D'après le brevet GB—A—1 114 497, il est connu de disposer plusieurs circuits semi-conducteurs sur un même substrat isolant ayant une haute conductivité thermique.

D'après l'article de Burkett dans la revue Electronics International, volume 54, No 7, avril 1981, pages 130—132, il est connu d'utiliser les excellentes propriétés d'isolation électrique et de conductivité thermique de l'oxyde de béryllium.

Il a déjà été proposé d'utiliser un dispositif où un élément calorifique et un élément thermo-sensible régulant l'élément calorifique constituent chacun une entité complètement dissociée de l'autre et simplement juxtaposée à l'autre, chacune de ces entités possédant sa propre armature et son propre dispositif de fixation sur le corps à chauffer. Dans le cas où l'élément calorifique et l'élément thermo-sensible sont des circuits semi-conducteurs, chacun des deux possède son propre boîtier et son propre dispositif de fixation. Le couplage thermique entre eux est, alors mal assuré (du fait de l'éloignement et de la résistance thermique des boîtiers). De plus, la résistance thermique entre l'élément calorifique et le corps à chauffer est importante. Dans la pratique, elle est de l'ordre de 2,5°C/W.

Par conséquent, il n'existe pas à l'heure actuelle de cellule de couplage thermique entre l'élément thermo-sensible et l'élément calorifique ayant un bon couplage thermique et dont la résistance thermique entre l'élément calorifique et le corps à chauffer soit faible.

La présente invention ne possède pas les inconvénients des systèmes décrits ci-dessus et permet une miniaturisation importante de ladite cellule par exemple dans un volume de dimensions 12 mm×12 mm×5 mm. Dans ce but, elle est caractérisée en ce que l'élément calorifique et l'élément thermo-sensible sont disposés sur un même support thermiquement conducteur. Ledit support est constitué par une plaque sur laquelle sont disposés les éléments thermo-sensibles et calorifiques. Lesdits éléments sont reliés électriquement par des moyens bien connus de l'homme de l'art. La plaque permet de placer l'élément thermo-sensible et l'élément calorifique à proximité l'un de l'autre sans qu'aucune armature ne vienne les séparer, ce qui augmente sensiblement le couplage thermique. La plaque dudit support a, également, l'avantage de permettre une bonne conduction thermique entre l'élément calorifique et l'enceinte, étant meilleure conductrice thermique que les boîtiers utilisés habituellement par l'homme de l'art. La résistance thermique entre l'élément calorifique et l'élément thermo-sensible est de préférence de l'ordre de 0,5°C/W, la distance entre ces deux éléments pouvant être de l'ordre de 5/10 mm. La résistance thermique entre l'élément calorifique et l'enceinte est de préférence inférieure à 1°C/W.

La cellule de couplage thermique selon l'invention est caractérisée en ce que l'élément calorifique et l'élément thermo-sensible sont liés par un conducteur métallique déposé sur ledit support. Ledit conducteur métallique a une meilleure conduction thermique que ledit support. En général, ledit conducteur métallique constitue une couche placée su ledit support, les éléments calorifiques et thermo-sensibles étant fixés sur ladite couche. En fait, la conduction thermique, entre lesdits éléments optimale pour un bon fonctionnement du couplage thermique n'est pas nécessairement maximale. Pour connaître la meilleure valeur de la conduction thermique entre lesdits éléments on procède par réglages successifs. Aussi, la présente invention est caractérisée en ce que ledit conducteur métallique comporte trois parties: une partie en contact thermique avec l'élément calorifique, une partie en contact thermique avec l'élément thermo-sensible et une partie de dimensions réglables, joint thermique des deux autres parties. Ainsi, par action sur les dimensions de la troisième partie considérée, un réglage du couplage thermique est aisément réalisable. Pratiquement, la dimension utile pour ledit réglage est la largeur de la troisième partie considérée. Elle peut être de l'ordre de 1 mm.

Ledit support sera, de préférence, un isolant électrique. En effet, en l'absence d'isolation électrique, il est nécessaire de placer au moins sous les sorties électriques de l'élément calorifique et plus particulièrement sous le collecteur des transistors utilisés comme élément calorifique, une feuille d'isolant électrique et plus particulièrement une feuille de mica pour éviter tout contact électrique entre lesdites sorties et l'enceinte. Or, cette feuille isolante électrique ne peut qu'augmenter la conduction thermique entre l'élément calorifique et l'enceinte.

Pratiquement, on utilisera pour ledit support une plaque en céramique. On utilise, de préférence, un support en oxyde de berylium. En effet, l'oxyde de berylium a une conductivité thermique très gande puisqu'elle est de 2,20 W/cm°C. Les métallisations peuvent être un alliage de palladium et d'argent ou du cuivre déposé selon le procédé appelé technologie couches épaisses (sérigraphie) connue de l'homme de l'art.

Selon un mode préférentiel de réalisation, la cellule de couplage thermique selon l'invention est caractérisée en ce que l'élément calorifique est fixé sur le support par l'intermédiaire d'une couche métallique comportant des ondulations, capables d'écouler des bulles d'air, sur la face tournée vers l'élément calorifique. Ledit support porte alors sur la zone où l'élément calorifique est disposé, une couche métallique comportant des conduits capillaires destinés à évacuer les bulles d'air. Lesdites bulles d'air se forment lorsque la soudure liquide est déposée sur ledit support. Lesdits conduits capillaires évacuent lesdites bulles d'air par capillarité avant que la soudure ne devienne solide. La conduction thermique entre l'élément calorifique et l'enceinte est ainsi améliorée. L'air étant un bon isolant thermique, il est préférable de placer une couche métallique, bonne conductrice thermique, pour supprimer lesdites bulles d'air. Pratiquement, les ondulations forment des conduits capillaires de hauteur de l'ordre de 10 µm à 20 µm et d'écartement de l'ordre de 100 µm, c'est-à-dire que la distance crête à crête est de l'ordre de 100 µm.

L'élément calorifique sera de préférence un circuit semi-conducteur. Par circuit semi-conducteur, on entend dans ce cas, un circuit tel qu'il puisse être monté en stabilisation de tension continue. Concernant ce type de circuit, on pourra se reporter à l'ouvrage de Robert D. Pascoe "Fondamentals of solid states electronics", John Wiley and Son, 1976, pages 225 à 255. En particulier, un tel circuit semi-conducteur peut être constitué d'un ou plusieurs transistors éventuellement reliés entre eux par des éléments résistifs, des diodes Zener etc...., l'ensemble pouvant être éventuellement introduit sur une pastille semi-conductrice.

L'élément thermo-sensible sera de préférence une thermistance à coefficient de température positif ou négatif ou une jonction P.N. Pour un meilleur couplage thermique entre les éléments thermo-sensibles et calorifiques, on utilise de préférence une thermistance.

Selon un autre mode préférentiel de réalisation, la cellule de couplage thermique selon l'invention est caractérisé en ce qu'elle comporte un capot isolant hermétiquement et dont le matériau a un coefficient de dilatation sensiblement égal à celui dudit support. Ledit capot recouvre ladite cellule sur tous les côtés à l'exception de celui de la plaque dudit support. Le boîtier assure l'étanchéité de la cellule par rapport à la poussière et aux impuretés du milieu ambiant. Afin que cette étanchéité soit parfaite, ledit capot est soudé à l'aide d'une couche métallique nommée préforme. Le capot est, alors métallisé aux points où il sera soudé et ledit support est recouvert d'une couche métallique aux points où ledit capot sera soudé. La soudure s'effectue entre ces deux métallisations et est ainsi étanche aux gaz. Afin d'éviter des contraintes entre ledit capot et ledit support, ledit capot sera de préférence en céramique de façon à avoir un coefficient de dilatation sensiblement égal à celui du support.

Selon un autre mode préférentiel de réalisation, le cellule de couplage thermique selon la présente invention est caractérisée en ce que la face du support opposée à ladite cellule ou face arrière comporte au moins une zone métallisée. Cette métallisation de la face arrière se présente sous la forme d'un damier, c'est-à-dire une succession de rectangles métallisés appliqués sur la face arrière. Cette succession n'est pas nécessairement régulière. Ladite métallisation permet d'obtenir par brasage une fixation sur l'enceinte de la cellule de couplage thermique avec une résistance thermique faible. Afin d'absorber les contraintes s'exerçant entre l'enceinte et la plaque dudit support, dues aux variations de température, la face arrière n'est pas entièrement métallisée. De préférence, la cellule de couplage thermique selon la présente invention est caractérisée en ce qu'une des zones métallisées est disposée sensiblement sous l'élément calorifique car cette métallisation assure une bonne conduction thermique entre l'élément calorifique et l'enceinte. Ladite métallisation brasée su l'enceinte donne de meilleurs résultats pour la conduction thermique entre l'élément calorifique et l'enceinte qu'un procédé consistant à placer sur ladite face une pâte conductrice thermique servant à coller ladite cellule sur l'enceinte, ledit procédé permettant de boucher les interstices remplis d'air donc d'améliorer la conduction thermique. Ladite métallisation bouche également ces interstices et est meilleure conductrice thermique que ladite pâte.

Pratiquement, l'enceinte munie d'une · ou plusieurs cellules de couplage thermique selon la présente invention comporte d'autres éléments thermo-sensibles sur son pourtour, non inclus dans une cellule de couplage thermique et régulant électriquement au moins un élément calorifique. Ces autres éléments thermo-sensibles sont disposés autour de l'enceinte et évaluent sa température directement. Les sorties de ces éléments thermo-sensibles sont branchées sur le circuit de régulation de l'élément calorifique ou des éléments calorifiques. Ainsi, la cellule de couplage thermique assure une régulation de l'élément calorifique avec une faible constante de temps puisqu'elle peut être inférieure à 1/100 s et permet une réaction rapide à une variation de température de l'élément calorifique. Les éléments thermo-sensibles disposés sur la périphérie de l'enceinte permettant d'affiner la régulation thermique en percevant ‚'e faibles écarts de température se produisant sur l'enceinte, il est alors moins important que la constante de temps soit dans leur cas plus élevée. L'enceinte munie de cellules de couplage thermique et d'éléments thermo-sensibles disposés sur sa périphérie permet de limiter les variations relatives de fréquence de l'oscillateur piézo-électrique à des ordres de grandeur de $10^{-10}$.

Géréralement, on dispose plusieurs cellules de couplage thermique autour de l'enceinte, les éléments calorifiques et thermo-sensibles étant en liaison électrique comme indiqué dans la demande de brevet européen EP—A—0 004 233.

L'invention sera mieux comprise à l'aide des figures suivantes qui représentent:

—la figure 1, suivant un dessin schématique, un mode de réalisation des circuits électriques d'un dispositf de réggulation thermique selon l'art antérieur,

—la figure 2, une enceinte munie du dispositif de régulation selon l'art antérieur,

—la figure 3, une cellule de couplage thermique selon l'invention, vue du dessus dudit support,

—la figure 4, l'agencement des couches de la cellule de couplage thermique selon l'invention, aux points de soudure dudit capot et de sorties des éléments de ladite cellule,

—la figure 5, la métallisation de la face arrière dudit support,

—les figures 6 et 7, respectivement en vue de dessus et en coupe, un mode de réalisation de la métallisation supportant un élèment calorifique.

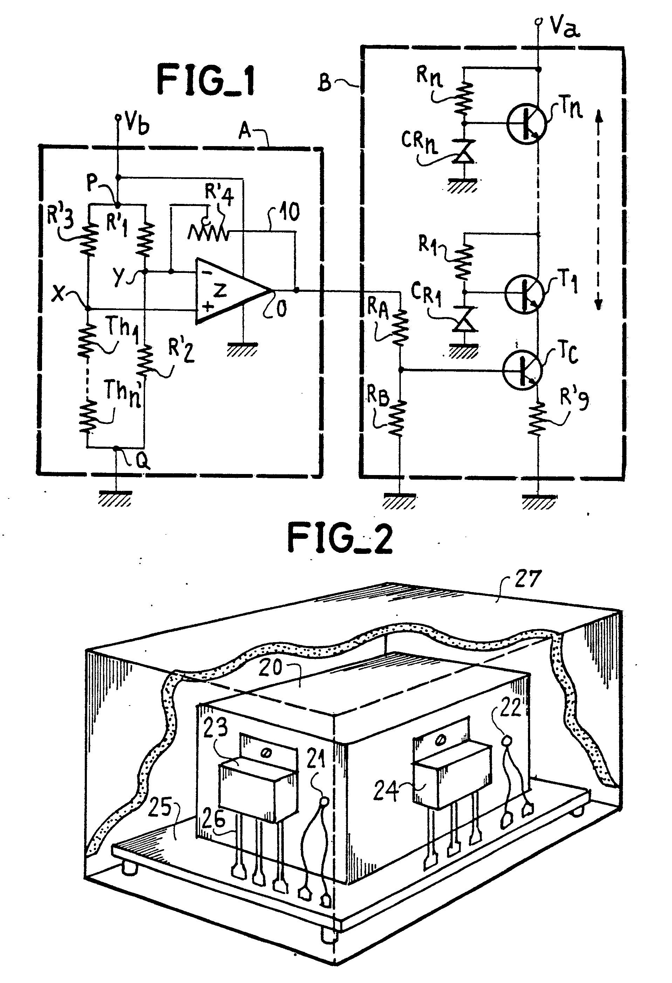

La figure 1 représente, suivant un dessin schématique, un mode de réalisation des circuits électriques d'un dispositif de régulation thermique.

Il se compose d'un circuit de mesure de température, repéré A, et d'un circuit de chauffage, repéré B.

Le circuit de mesure A comporte un ou plusieurs éléments thermo-sensibles ou capteurs de température, connectés en série, tels que $Th_1...Th_{n'}$. Ces capteurs sont inclus dans une des branches d'un pont de résistances dont les autres éléments sont R'1, R'2, R'3, alimenté en tension continue aux extrémités PQ d'une de ses diagonales.

Les extrémités de l'autre de ses diagonales XY sont reliées aux deux entrées d'un amplificateur différentiel Z, muni d'une boucle sortie-entrée 10 comprenant une résistance variable R'4.

Le fonctionnement d'un tel circuit de mesure est le suivant: pour une température d'enceinte quelconque, les capteurs $Th_1...Th_{n'}$ prennent une résistance donnée; le pont de résistance R'1, R'2, R'3, $Th_1+...+Th_{n'}$ n'est pas équilibré, et une tension apparaît aux extrémités XY; l'amplificateur différentiel Z, attaqué par cette tension délivre à sa sortie O un signal électrique ainsi lié à la température de l'enceinte, signal qui s'annule seulement pour une valeur particuliére de cette température. Il est possibe de prédéterminer cette valeur par ajustement de la valeur de la résistance R'2; par ailleurs, la valeur absolue du signal délivré par le circuit de mesure peut être réglée par ajustement de la valeur de la résistance R'4.

Le circuit de chauffage B comporte une chaîne de transistors connectés en série par leur émetteur et collecteur, repérés de $T_1$ à $T_n$.

Les transistors $T_1$ à $T_n$ sont montés en régulateurs de tension. Pour cela, chaque base est maintenue à un potentiel constant par un pont diviseur résistance-diode, tel que $R_n$, $CR_n$ pour le transistor $T_n$.

Le transistor $T_c$ assure la fonction de transistor de commande. Par suite de la fonction de stabilisation de tension assumée par chaque transistor de la chaîne, chacun des n transistors ainsi que le transistor $T_c$ est soumis à une fraction de la tension totale $V_A$, sensiblement

$$\frac{V_A}{n+1}.$$

La base b du transistor $T_c$ est reliée à la sortie de l'amplificateur différentiel à travers un pont diviseur $R_A$, $R_B$ dont le rôle est d'assurer une liaison tenant compte des conditions particulières de polarisation de l'amplificateur différentiel Z.

En effet, cet amplificateur est alimenté sur le mode dit "en mono-tension"; il n'existe alors pas de tension de référence par rapport à laquelle il soit possible de bloquer le transistor $T_c$. L'utilisation d'un pont diviseur de rapport convenable permet de diminuer la tension résiduelle de sortie de l'amplificateur à son niveau bas, pour l'amener à une valeur inférieure à la tension de blocage de la base du transistor $T_1$.

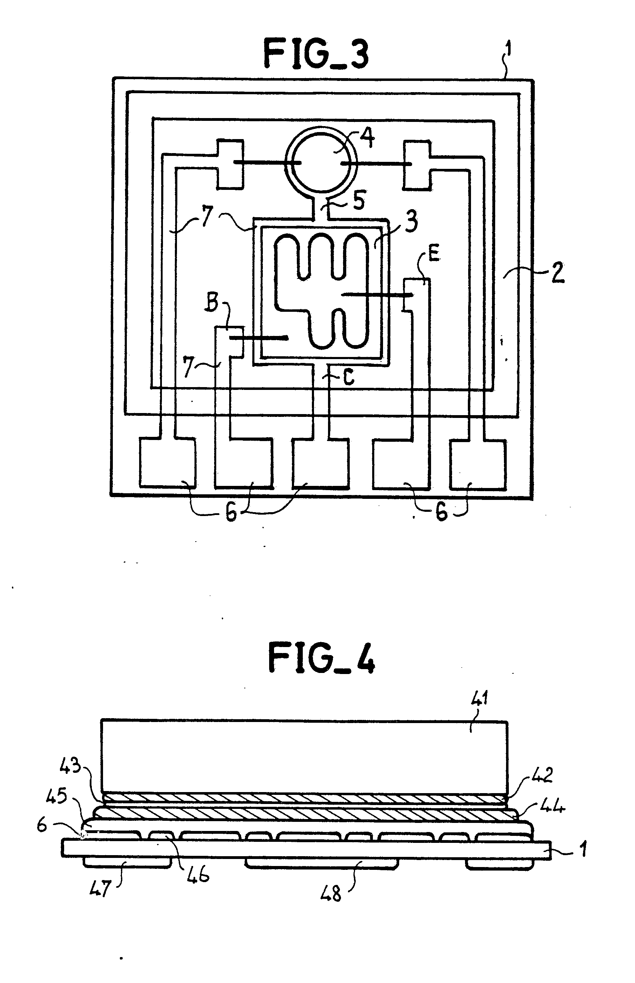

La figure 2 représente un mode de mise en oeuvre pratique particulièrement simple du dispositif de régulation thermique selon l'art antérieur, dans le cas, donné à titre d'exemple, de la régulation de la température d'un cristal piézo-électrique oscillant contenu dans une enceinte close; cette enceinte fait usuellement partie intégrante du produit fini, industriellement commercialisé sous ce nom.

Pour cela, les capteurs de température tels que 21 et 22 et les transistors de chauffage tels que 23 et 24 sont directement fixés sur l'enceinte étanche 20 contenant le cristal piézo-électrique. Par ailleurs, l'enceinte est montée directement sur le circuit de commande 25, qui sert ainsi de support, et est avantageusement réalisé suivant la technique des circuits imprimés.

Les connexions de raccordement 26 sont de cette façon très courtes. L'isolement thermique entre l'enceinte et boîtier de protection extérieur tel que 27 peut être assuré soit par un matériau isotherme, soit simplement par la couche d'air ambiant, si l'ensemble est monté hermétiquement dans le boîtier.

Dans le cas de la présente invention, d'autres éléments thermo-sensibles non inclus dans la cellule de couplage thermique selon l'invention peuvent être montés sur l'enceinte 20 de la même façon que les capteurs de température 21 et 22.

La figure 3 repésente une cellule de couplage thermique selon l'invention, vue du dessus du support. Sur la plaque de céramique 1, sont disposés l'élément calorifique 3 et l'élément thermo-sensible 4. Une couche métallique 7 déposée sur la plaque 1 et constituée de plusieurs zones séparées électriquement assure la conduction électrique et les sorties électriques 6 desdits éléments 3 et 4. L'élément calorifique 3 est un transistor, relié électriquement à une des couches métalliques 7 par des fils électriques câblés par thermo-compression, en E pour son émetteur, en B pour sa base et en C pour son collecteur. L'élément thermo-sensible 4 peut être soit une diode sous forme de puce, soit une thermistance encapsulée sous verre ou sérigraphiée. Dans le cas où l'élément thermo-sensible est une thermistance encapsulée sous verre ou une diode, il est relié électriquement à la couche métallique 7 par des fils électriques câblés par collage. Dans le cas où l'élément thermo-sensible est une thermistance sérigraphiée, la couche métallique 7 et la thermistance s'interpénètrent aux points de jonction électrique. Les sorties de l'élément thermo-sensible sont branchées en lieu et place des sorties de l'un des éléments ($Th_1...Th_{n'}$) de la figure 1. Les sorties de l'élément calorifique sont branchées en lieu et place des sorties de l'un des transistors ($T_1...T_n$). Un emplacement permettant la soudure d'un capot est repéré en 2 sur le pourtour de la plaque de céramique 1.

Une couche métallique 5, déposée sur la plaque céramique 1 joue un rôle de conduction thermique entre l'élément calorifique 3 et l'élément thermo-sensible 4. En effet, plus particulièrement, dans le cas où la thermistance est encapsulée sous verre, il est nésessaire d'accroître la conduction thermique entre l'élément thermo-sensible et l'élément calorifique, le verre étant un isolant thermique. Le conducteur thermique 5 comporte trois parties: une partie sur laquelle est fixé l'élément calorifique, une partie sur laquelle est fixé l'élément thermo-sensible, une partie liant thermiquement les deux autres. Le réglage de la conduction thermique qui fournit le meilleur couplage thermique se fait par modification de la largeur de la troisième partie. La longueur de cette troisième partie est avantageusement de l'ordre de 1 mm.

La figure 4 représente l'agencement des couches de la cellule de couplage thermique selon l'invention aux points de soudure dudit capot et de sorties des éléments de ladite cellule ou bien une coupe de ladite cellule à l'emplacement 2 de la soudure dudit capot. Les couches successives de ladite cellule sont:

—une couche de métallisation de la face arrière de la plaque céramique 1, représentée en 47 et 48. Cette métallisation permet le brasage de ladite cellule sur l'enceinte et une bonne conduction thermique entre l'élément calorifique et l'enceinte. Pour ce faire, la face arrière est métallisée sur sa surface centrale 48 opposée à l'élément calorifique 3. Cette métallisation ne s'étend pas sur toute la face arrière, mais n'est réalisée que par des parties périphériques 47, afin de limiter les contraintes dues à des coefficients de dilatation différents selon les matériaux de ladite enceinte et de ladite cellule;

—la plaque de céramique 1;

—les sorties électriques 6 de la cellule;

—des couches diélectriques 45 et 46 isolant électriquement les sorties 6 des métallisations de la soudure du capot. La couche diélectrique 46 placée entre les sorties 6 est un diélectrique bouchon évitant les dénivellations de la surface supérieure de la couche diélectrique 45 dues à la présence des sorties 6 sous une couche diélectrique 45;

—une métallisation 44 de la couche diélectrique 45, servant à souder le capot 41, la métallisation 44 s'étendant sur tout l'emplacement 2;

—la soudure proprement dite ou préforme entre la métallisation 44 et la métallisation 42 du capot 41. Cette soudure est étanche au gaz;

—la métallisation 42 du capot 41;

—le capot 41.

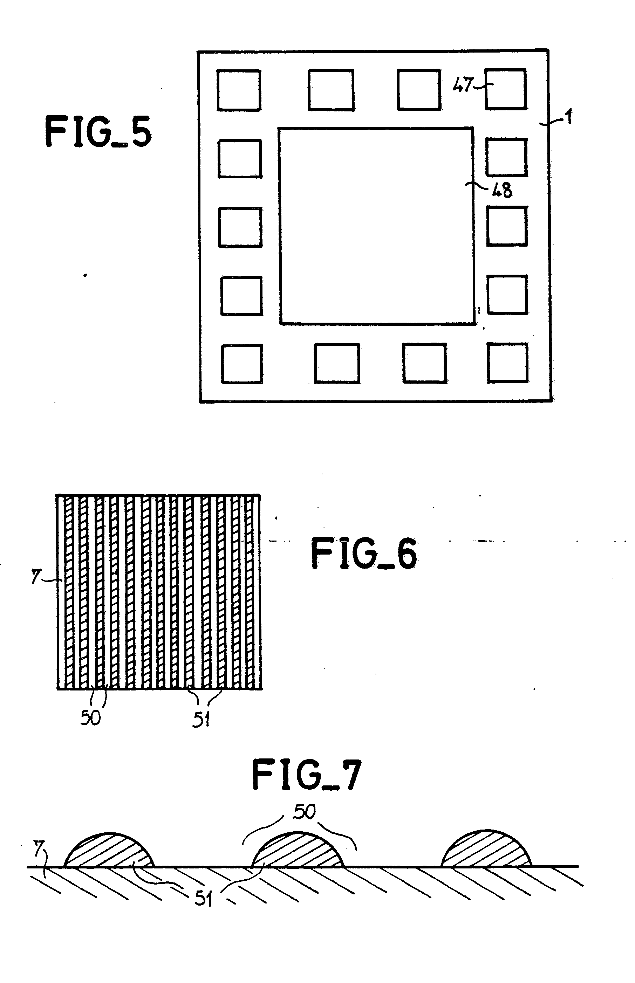

La figure 5 représente la face arrière de ladite cellule. Sur cette figure, les mêmes éléments qu ceux de la figure 4 portent les mêmes références. La face arrière est sensiblement un carré dont la largeur des côtés est de l'ordre de 12 mm. La surface 48 métallisée sur la face arrière du support 1 est également sensiblement un carré, placé au centre de la face arrière et dont les côtés sont parallèles à ceux de la face arrière. Les dimensions du carré de la surface 48 sont égales ou supérieures à celles de l'élément calorifique. L'ordre de grandeur du côté de ce carré est de 6 mm. Entre le carré constitué par la surface 48 et le contour carré de la face arrière se situe une bande sur laquelle sont disposées les parties 47 métallisées, régulièrement espacées tout autour de la surface 48, les parties 47 étant des carrés ou des rectangles dont les côtés sont parallèles à ceux de la surface 48 et dont les côtés sont de l'ordre de 1 mm à à 2 mm. On utilise également et plus particulièrement pour la surface 48, un rectangle de longueur sensiblement égale à 7 mm et de largeur sensiblement égale à 5 mm.

Selon les figures 6 et 7, la métallisation 7 comporte des ondulations 51 en relief séparées par des conduits 51. Ces conduits ont une dimension telle qu'ils éliminent les bulles d'air restantes lors de la soudure de l'élément calorifique sur la métallisation 7, par action des forces capillaires. Les ondulations 51 sont réalisées par sérigraphie. A titre d'exemple, leur hauteur est de 10 à 20 microns, leur largeur d'environ 50 microns et elles sont séparées par des intervalles d'environ 50 microns, ce qui donne un pas de l'ordre de 100 microns.

**Revendications**

1. Cellule de couplage thermique entre un élément calorifique à semi-conducteurs et un élément thermo-sensible pour la régulation thermique d'une enceinte destinée notamment à un oscillateur piézo-électrique, l'élément thermo-sensible (4) étant disposé à proximité de l'élément calorifique (3), les deux éléments étant montés sur un support isolant (1) et étant reliés par un conducteur métallique (5), caractérisée en ce que ledit support isolant est un conducteur thermique et en ce que le conducteur métallique (5) est disposé sur le support et comporte trois parties, la première en contact thermique avec l'élément thermo-sensible, la seconde en contact thermique avec l'élément calorifique et la troisième partie de dimensions réglables, reliant thermiquement la première à la seconde partie.

2. Cellule de couplage thermique selon la revendication 1, caractérisée en ce que le support (1) est un isolant électrique.

3. Cellule de couplage thermique selon l'une des revendications 1 ou 2, caractérisée en ce que ledit support (1) est en oxyde de béryllium.

4. Cellule de couplage thermique selon l'une des revendications 1 à 3, caractérisée en ce que l'élément calorifique (3) est fixé sur le support (1) par l'intermédiaire d'une couche métallique comportant des ondulations, destinées à écouler les bulles d'air formées pendant la soudure, sur la face tournée vers l'élément calorifique (3).

5. Cellule de couplage thermique selon la revendication 4, caractérisée en ce que les ondulations sont des conduits capillaires de hauteur de l'ordre de 10 µm à 20 µm, de largeur d'environ 50 µ et disposés selon un pas de l'ordre de 100 µm.

6. Cellule de couplage thermique selon la revendication 1, caractérisée en ce que la troisième partie (5) a une longueur de l'ordre de 1 millimètre.

7. Cellule de couplage thermique selon l'une des revendications précédentes, caractérisée en ce que l'élément calorifique (3) est un premier circuit semi-conducteur.

8. Cellule de couplage thermique selon la revendication 7, caractérisée en ce que l'élément calorifique (3) est un transistor.

9. Cellule de couplage thermique selon l'une des revendications précédentes, caractérisée en ce que l'élément thermo-sensible (4) est un deuxième circuit semi-conducteur.

10. Cellule de couplage thermique selon l'une des revendications 1 à 9, caractérisée en ce que l'élément thermo-sensible (4) est une thermistance.

11. Cellule de couplage thermique selon la revendication 9, caractérisée en ce que l'élément thermo-sensible (4) est une jonction P.N.

12. Cellule de couplage thermique selon l'une des revendications précédentes, caractérisée en ce que la face du support (1) opoosée aux éléments calorifiques (3) et thermo-sensibles (4) comporte au moins une zone métallisée (47, 48).

13. Cellule de couplage thermique (1) selon la revendication 12, caractérisée en ce qu'une (48) des zones métallisées (47, 48) est disposée sensiblement sous l'élément calorifique (3).

14. Cellule de couplage thermique selon l'une des revendications précédentes, caractérisée en ce que ladite cellule comporte un capot (41), isolant hermétiquement ladite cellule et dont le matériau a un coefficient de dilatation sensiblement égal à celui du support (1).

15. Cellule de couplage thermique selon la revendication 14, caractérisée en ce que le capot est brasé sur une métallisation du support.

16. Enceinte thermostatée caractérisée en ce qu'elle comporte une ou plusieurs cellules de couplage thermiques selon l'une des revendications 1 à 15.

**Patentansprüche**

1. Zelle zur thermischen Kopplung zwischen einem wärmeerzeugenden Halbleiter-Element und einem wärmeempfindlichen Element für die Wärmeregulierung eines Raums, der insbesondere für einen piezo-elektrischen Oszillator bestimmt ist, wobei das wärmeempfindliche Element (4) in der Nähe des wärmeerzeugenden Elements (3) angeordnet ist und die beiden Elemente auf einem isolierenden Halter (1) angebracht und durch einen metallischen Leiter (5) miteinander verbunden sind, dadurch gekennzeichnet, daß der isolierende Halter ein Wärmeleiter ist und daß der metallische Leiter (5) auf dem Halter angeordnet ist und drei Teile aufweist, von denen der erste in thermischem Kontakt mit dem wärmeempfindlichen Element steht, der zweite in thermischem Kontakt mit dem wärmeerzeugenden Element steht und der dritte Teil regelbare Dimensionen besitzt und den ersten Teil thermisch mit dem zweiten Teil verbindet.

2. Thermische Kopplungszelle nach Anspruch 1, dadurch gekennzeichnet, daß der Halter (1) ein elektrischer Isolator ist.

3. Thermische Kopplungszelle nach einem der Ansprüche 1 oder 2, dadurch gekennzeichnet, daß der Halter (1) aus Berylliumoxid ist.

4. Thermische Kopplunszelle nach einem der Ansprüche 1 bis 3, dadurch gekennzeichnet, daß das wärmeerzeugende Element (3) auf dem Halter (1) über eine Metallschicht befestigt ist, die auf der dem wärmeerzeugenden Element (3) zugewandten Seite Wellen aufweist, die die während des Lötens entstehenden Wellen ableiten sollen.

5. Thermische Kopplungszelle nach Anspruch 4, dadurch gekennzeichnet, daß diese Wellen Kapillarleitungen mit einer Höhe von etwa 10 μm bis 20 μm, einer Breite von etwa 50 μm sind, die in einem regelmäßigen Abstand von etwa 100 μm angeordnet sind.

6. Thermische Kopplungszelle nach Anspruch 1, dadurch gekennzeichnet, daß der dritte Teil (5) eine Länge von etwa 1 mm hat.

7. Thermische Kopplungszelle nach einem der vorstehenden Ansprüche, dadurch gekennzeichnet, daß das wärmeerzeugende Element (3) ein erster Halbleiterkreis ist.

8. Thermische Kopplungszelle nach Anspruch 7, dadurch gekennzeichnet, daß das wärmeerzeugende Element (3) ein Transistor ist.

9. Thermische Kopplungszelle nach einem der vorstehenden Ansprüche, dadurch gekennzeichnet, daß das wärmeempfindliche Element (4) ein zweiter Halbleiterkreis ist.

10. Thermische Kopplungszelle nach einem der Ansprüche 1 bis 9, dadurch gekennzeichnet, daß das wärmeempfindliche Element (4) ein Thermistor ist.

11. Thermische Kopplungszelle nach Anspruch 9, dadurch gekennzeichnet, daß das wärmeempfindliche Element (4) eine PN-Junktion ist.

12 Thermische Kopplungszelle nach einem der vorstehenden Ansprüche, dadurch gekennzeichnet, daß die den Wärmeerzeugenden (3) und wärmeempfindlichen Elementen (4) abgewandte Seite des Halters (1) mindestens einen metallisierten Bereich (47, 48) aufweist.

13. Thermische Kopplungszelle (1) nach Anspruch 12, dadurch gekennzeichnet, daß einer (48) der metallisierten Bereiche (47, 48) im wesentlichen unter dem wärmeerzeugenden Element (3) angeordnet ist.

14. Thermische Kopplungszelle nach einem der vorstehenden Ansprüche, dadurch gekennzeichnet, daß die Zelle eine Haube (41) aufweist, die diese Zelle hermetisch isoliert und deren Material einen Ausdehnungskoeffizienten hat, der im wesentlichen gleich dem des Halters (1) ist.

15. Thermische Kopplungszelle nach Anspruch 14, dadurch gekennzeichnet, daß die Haube auf eine Metallisierung des Halters gelötet ist.

16. Thermostatisierter Bereich, dadurch gekennzeichnet, daß er eine oder mehrere thermische Kopplungszellen nach einem der Ansprüche 1 bis 15 aufweist.

**Claims**

1. A thermal coupling cell between a heat producing element with semiconductors and a heat-sensitive element for the temperature stabilisation of an enclosure, especially intended for a piezo-electric oscillator, the heat-sensitive element being disposed close to the heat producing element (3), the two elements being mounted on an insulating support (1) and being interconnected by a metallic conductor (5), characterized in that said insulating support is a heat conductor and that the metallic conductor (5) is disposed on the support and comprises three parts, the first one being in thermal contact with the heat-sensitive element, the second one being in thermal contact with the heat producing element and the third part having adjustable dimensions and thermally connecting the first to the second part.

2. A thermal coupling cell according to claim 1, characterised in that the support (1) is an electrical insulator.

3. A thermal coupling cell according to one of claims 1 or 2, characterized in that said support (1) is made of beryllium oxide.

4. A thermal coupling cell according to one of claims 1 to 3, characterized in that the heat producing element (3) is fixed to the support (1) via a metal layer comprising, on the face turned towards the heat producing element (3), undulations, intended to evacuate air bubbles formed during welding.

5. A thermal coupling cell according to claim 4, characterized in that the undulations are capillary ducts with a height of approximately 10 μm to 20 μm, a width of approximately 50 μm and

disposed with a spacing of approximately 100 μm.

6. A thermal coupling cell according to claim 1, characterized in that the third part (5) has a length of approximately 1 mm.

7. A thermal coupling cell according to one of the preceding claims, characterized in that the heat producing element (3) is a first semiconductor circuit.

8. A thermal coupling cell according to claim 7, characterized in that the heat producing element (3) is a transistor.

9. A thermal coupling cell according to one of the preceding claims, characterized in that the heat-sensitive element (4) is a second semiconductor circuit.

10. A thermal coupling cell according to one of claims 1 to 9, characterized in that the heat-sensitive element is a thermistor.

11. A thermal coupling cell according to claim 9, characterized in that the heat-sensitive element (4) is a PN-junction.

12. A thermal coupling cell according to one of the preceding claims, characterized in that the face of the support (1) which is opposed to the heat producing element (3) and to the heat-sensitive element (4) comprises at least one metallized zone (47, 48).

13. A thermal coupling cell (1) according to claim 12, characterized in that one (48) of the metallized zones (47, 48) is disposed substantially beneath the heat producing element (3).

14. A thermal coupling cell according to one of the preceding claims, characterized in that said cell comprises a cap (41) which hermetically insulates said cell and the material of which has an expansion coefficient which is essentially equal to that of the support (1).

15. A thermal coupling cell according to claim 14, characterized in that the cap is soldered on a metallisation of the support.

16. A thermostatically controlled enclosure, characterized in that it comprises one or several thermal coupling cells according to one of claims 1 to 15.

# FIG_1

# FIG_2

# FIG_3

# FIG_4

FIG_5

47

1

48

FIG_6

7

50    51

FIG_7

50

7

51